# EUROPÄISCHE PATENTANMELDUNG

(11) **EP 2 291 062 A1**
(43) Veröffentlichungstag der Anmeldung: **02.03.2011**
(21) Anmeldenummer: 10170218.1
(22) Anmeldetag: 21.07.2010
(51) Int. Cl.: H05K 3/32, H05K 1/11, H05K 3/00, H05K 3/30

(54) **Verfahren zur Herstellung von Anschlussbohrungen mit optimierten Klemmkragen**

(30) Priorität: 07.08.2009 DE 102009028349
(71) Anmelder: Endress + Hauser GmbH + Co. KG, 79689 Maulburg (DE)
(72) Erfinder: Birgel, Dietmar, 79650 Schopfheim (DE); Glatz, Franz, 79106 Freiburg (DE); Hippin, Christoph, 79639 Grenzach-Wyhlen (DE)
(74) Vertreter: Andres, Angelika Maria

(57) **Zusammenfassung**

Um die gewünschte Passgenauigkeit von Anschlusspin und Klemmkragen (30) selbst bei Fertigungsschwankungen bei der Herstellung von Anschlussbohrungen (19) mit Klemmkragen (30) und bei Fertigungsschwankungen der Bauteilehersteller in Bezug auf die Anschlusspins ihrer THT-Bauteile zu erreichen, wird ein Verfahren zur Herstellung von solchen Anschlussbohrungen (19) vorgeschlagen, bei dem zunächst Anschlussbohrungen (19) mittels zweier gegenläufiger Sacklochbohrungen hergestellt werden, die nach anschließendem Galvanisieren der Anschlussbohrungen (19) durch Einpressen eines Einpresstempels (38) mit polygonalem Einpressquerschnitt im Bereich des Klemmkragens (30) in gewünschter Weise nachgeformt werden.

## Beschreibung

Die Erfindung betrifft ein Verfahren zur Herstellung von Anschlussbohrungen mit optimierten Klemmkragen in einer Leiterplatte.

Es ist bekannt, für Anschlusspins bedrahteter elektronischer oder elektrischer Bauteile Anschlussbohrungen vorzusehen, die eine Klemmvorrichtung aufweisen, mittels der die Anschlusspins in den Anschlussbohrungen eingeklemmt und gehalten werden. Dies ist besonders wichtig, wenn die Leiterplatte nach Bestücken mit bedrahteten Bauteilen gewendet werden soll. Dies ist auch wichtig, wenn bedrahtete Bauteile zu schwer oder eine ungünstige Masseverteilung aufweisen, und sie beim Transport der bestückten Leiterplatte zu einem Lötautomaten dazu neigen, ihre Lage zu verändern. So ist beispielsweise aus der Offenlegungsschrift DE 10344261 A1 bekannt, Anschlussbohrungen mit einer darin befindlichen Klemmvorrichtung in Form einer im wesentlichen ringförmigen Querschnittsverengung aus zwei gegenläufigen Sacklochbohrungen in der Leiterplatte herzustellen. Diese Art von Anschlussbohrungen mit integriertem Klemmkragen wird auch unter der Bezeichnung "Softlock-Bohrungen" vermarktet.

Mit dem Begriff "bedrahtete Bauteile" seien hier und im Folgenden alle Bauteile gemeint, deren elektrische Anschlüsse aus ihrem Gehäuse als so genannte Anschlusspins, Anschlussstifte oder Anschlussdrähte herausgeführt sind. Dementsprechend umfasst der Begriff "Anschlusspins" hier und im Folgenden nicht nur die oben beschriebenen Anschlusspins bedrahteter Bauteile sondern auch Anschlussstifte und Anschlussdrähte. Zur elektrischen Kontaktierung werden sie in Anschlussbohrungen gesteckt und dort mit Anschlusspads verlötet. Bedrahtete Bauteile, deren Anschlusspins in Anschlussbohrungen gesteckt sind, dass sie die Leiterplatte durchgreifen, werden auch als "THT-" (Through Hole Technology) Bauteile bezeichnet. Da, wie oben beschrieben, Anschlussbohrungen mit Klemmkragen nur für spezielle THT-Bauteile erforderlich sind, werden üblicherweise nicht alle die Leiterplatte durchgreifenden Anschlussbohrungen mit einem Klemmkragen ausgerüstet.

Um die gewünschte Klemmwirkung zu erzielen, sollten diese besonderen Anschlussbohrungen mit Klemmkragen auf den Außendurchmesser und die Form der festzuklemmenden Anschlusspins abgestimmt werden. In der Praxis hat sich gezeigt, dass die Passgenauigkeit von Anschlusspin und Klemmkragen recht problematisch ist. Einerseits ist es schwierig, Anschlussbohrungen mit Klemmkragen mit gleich bleibender Genauigkeit herzustellen, andererseits stellen die Fertigungsschwankungen der Bauteilehersteller in Bezug auf die Anschlusspins ihrer THT-Bauteile ein großes Problem dar.

Der vorliegenden Erfindung liegt daher die Aufgabe zugrunde, Klemmkragen in Anschlussbohrungen zu optimieren, um die oben genannten Probleme zu kompensieren und die Klemmwirkung der Klemmkragen an die jeweiligen Erfordernisse anzupassen.

Diese Aufgabe wird nach der Erfindung gelöst durch ein Verfahren zur Herstellung von Anschlussbohrungen mit optimierten Klemmkragen in einer Leiterplatte mit folgenden Verfahrensschritten:
a) Herstellen der Anschlussbohrungen mittels ersten Sacklochbohrungen von der ersten Seite der Leiterplatte her und zweiten Sacklochbohrungen von der zweiten Seite der Leiterplatte her, derart, dass sich die jeweils zu einer Anschlussbohrung gehörenden zwei Sacklochbohrungen in ihren Bohrlochspitzen wenig überdecken;
b) galvanisieren der Anschlussbohrungen der Leiterplatte und Schaffung einer Metallhülse in den Anschlussbohrungen; und
c) einführen und einpressen eines Einpresstempels mit polygonalem Einpressquerschnitt in die Anschlussbohrungen zum Verformen der Metallhülse im Bereich des Klemmkragens.

Bei einer besonderen Ausführungsform des erfindungsgemäßen Verfahrens wird zwischen den oben genannten Schritten a) und b) von einer Seite der Leiterplatte her im Zentrum der Sacklochbohrungen eine die beiden Sacklochbohrungen durchgreifende dritte Bohrung mit einem gegenüber den Sacklochbohrungen kleinerem Durchmesser gebohrt.

Besondere Ausführungsformen des erfindungsgemäßen Verfahrens sehen eine Vielzahl von Einpresstempeln auf einer Trägerplatte vor, so dass in einem Arbeitsgang eine Vielzahl von Anschlussbohrungen der Leiterplatte oder von mehreren Leiterplatten in einem Nutzen behandelt werden können.

Bei einer weiteren Ausführungsform des erfindungsgemäßen Verfahrens sind mehrere Einpresstempel mit unterschiedlichem Querschnitt auf einer Trägerplatte angeordnet.

Bei wieder einer anderen Ausführungsform des erfindungsgemäßen Verfahrens weist der Einpresstempel in dem Bereich, der in die Anschlussbohrungen eingepresst wird, eine Konizität auf.

In einem weiteren Verfahren nach der Erfindung ist vorgesehen, dass die Leiterplatte bzw. der Nutzen beim Einpressvorgang auf einer Auflage aufliegt und sich unter jeder zu behandelnden Anschlussbohrung ein Widerlager befindet.

Eine besondere Ausführungsform des erfindungsgemäßen Verfahrens sieht vor, dass die Leiterplatten bzw. Nutzen stapelweise verarbeitet werden, indem der oder die Einpressstempel, bei Mehrfachanordnung von Einpressstempeln auf der Trägerplatte, in Anschlussbohrungen mehrerer übereinander liegender Leiterplatten eingepresst werden.

Der große Vorteil der Erfindung besteht darin, die Ungenauigkeiten und unerwünschten Toleranzen, die bei der Herstellung von Anschlussbohrungen mit Klemmkragen auftreten durch kontrollierte Verformung des Klemmkragens in Bezug auf die für die betreffenden Anschlussbohrungen vorgesehenen Anschlusspins zu kompensieren und zu optimieren.

Der in weiterer Ausgestaltung der Erfindung vorgesehene Einpressstempel, der in dem Bereich, der in die Anschlussbohrungen eingepresst wird, eine Konizität aufweist, ermöglicht eine genaue Steuerung der gewünschten Verformung durch Variation des Einpressdrucks. Vorteilhaft für eine kontrollierte Verformung sind auch die Einpressstempel mit unterschiedlicher Querschnittsform. Damit können die für den betreffenden Anschlusspin optimalen Klemm- und Haltekräfte im deformierten Klemmkragen eingestellt werden.

Die Erfindung wird nachfolgend unter Hinweis auf die in der beigefügten Zeichnung veranschaulichten Ausführungsbeispiele genauer beschrieben und erläutert. Dabei zeigen:
- Fig. 1:: eine Schnittdarstellung einer aus Sacklochbohrung gebildeten Anschlussbohrung in einer Leiterplatte;
- Fig. 2:: die Anschlussbohrung nach Fig. 1 mit einer Metallhülse;
- Fig. 3:: die Anschlussbohrung nach Fig. 2 in einer Draufsicht auf der erste Seite der Leiterplatte;
- Fig. 4:: die Anschlussbohrung nach Fig. 2 mit einem 4-kantigen Einpressstempel und einem Widerlager auf einer Auflage in verkleinerter Darstellung;
- Fig. 5:: die Anschlussbohrung nach Fig. 4 nach der erfindungsgemäßen Verformung durch den Einpressstempel nach Fig. 4 in einer Draufsicht auf die erste Seite der Leiterplatte;
- Fig. 6:: ein anderes Ausführungsbeispiel einer erfindungsgemäßen Anschlussbohrung nach Fig. 4 nach der erfindungsgemäßen Verformung durch einen 6-kantigen Einpressstempel in einer Draufsicht; und
- Fig. 7:: eine erfindungsgemäße Trägerplatte mit einer Vielzahl von Einpressstempeln.

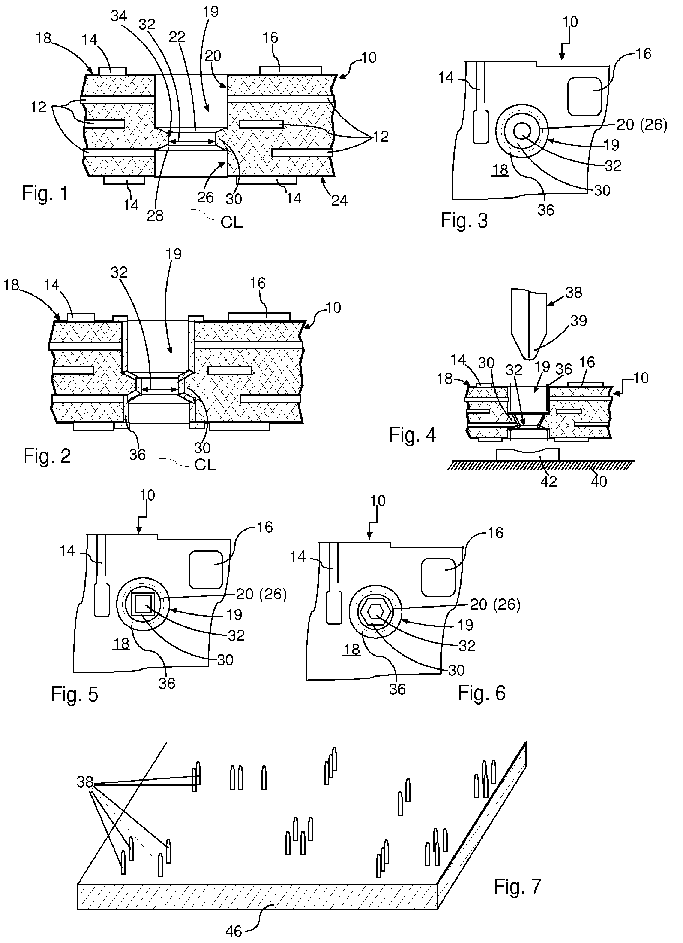

In Fig. 1 ist ein Ausschnitt einer mehrlagigen Leiterplatte 10 in einer Schnittdarstellung veranschaulicht. Im Innern der Leiterplatte 10 sind mehrere leitende Innenschichten bzw. Leiterbahnen 12 angedeutet. Zur weiteren Veranschaulichung sind auf einer ersten Seite 18 der Leiterplatte 10 eine äußere Leiterbahn 14 und ein Anschlusspad 16 dargestellt angedeutet. Die hier beispielhaft dargestellte Leiterplatte 10 ist beidseitig bestückbar, so dass auf einer zweiten Seite 24 der Leiterplatte 10 ebenfalls eine äußere Leiterbahn 14 angedeutet sind. Beispielhaft ist hier eine aus Sacklochbohrungen 20, 26 gebildete Anschlussbohrung 19 in der Leiterplatte 10 illustriert, die mit einem Klemmkragen 30 ausgestattet ist.

Von der ersten Seite 18 der Leiterplatte 10 her wird dazu die erste Anschlussbohrung 20 in die Leiterplatte 10 gebohrt. Die erste Sacklochbohrung 20 durchdringt die Leiterplatte 10 nicht, sondern erbohrt mit einer Bohrspitze 22 nur etwa 2/3 der Leiterplatte 10. Von der zweiten Seite 24 der Leiterplatte 10 her wird die zweite Sacklochbohrung 26 derart gebohrt, das sie gegenläufig und in etwa achsgleich zur ersten Sacklochbohrung 20 verläuft, wobei eine Bohrlochspitze 28 der zweiten Sacklochbohrung 26 die Bohrlochspitze 22 der ersten Anschlussbohrung 20 nur wenig durchdringt. Auf diese Weise wird im Innern der Anschlussbohrung 19 ein ringförmiger Klemmkragen 30 gebildet, der letztlich als Klemmvorrichtung zum sicheren Festhalten eines in die Anschlussbohrung 19 gesteckten, hier nicht dargestellten Anschlusspins eines THT-Bauteils dient.

Um einen gewünschten lichten Durchgang 32 in der Anschlussbohrung 19 an den dort vorgesehenen Anschlusspins eines THT-Bauteils anzupassen, kann, wie in Fig. 1 illustriert, eine dritte Bohrung 34 mit einem kleineren Durchmesser als die Sacklochbohrungen 20, 26 von einer beliebigen Seite der Leiterplatte her, achsgleich zu den Sacklochbohrungen 20, 26 gebohrt werden. Auf diese Weise kann die Einpresskraft, die für das Einpressen des dort vorgesehenen Anschlusspins eines THT-Bauteils gewünscht ist, grob eingestellt werden.

Zur Veranschaulichung ist in Fig. 1 eine allen Bohrungen 20, 26, 34 gemeinsame Mittellinie CL dargestellt, die auch die Mittellinie der Anschlussbohrung 19 ist. Obwohl zur Vereinfachung der Darstellung in Fig. 1 die erste Sacklochbohrung 20 in etwa den gleichen Durchmesser aufweist wie die zweite Sacklochbohrung 26 ist dies nicht zwingend notwendig.

Nach Schaffung der Anschlussbohrung 19 bzw. aller Anschlussbohrungen der Leiterplatte 10 wird die Leiterplatte galvanisiert, um die Anschlussbohrung 19 und die anderen Anschlussbohrungen der Leiterplatte 10 jeweils mit einer Metallhülse 36 auszukleiden, wie in Fig. 2 veranschaulicht. Fig. 2 verdeutlicht auch, dass der lichte Durchgang 32, in dem letztlich der für diese Anschlussbohrung 19 vorgesehene Anschlusspin festgehalten werden soll, infolge der Galvanisierung verringert wurde.

Fig. 3 illustriert die Anschlussbohrung nach Fig. 2 in einer Draufsicht auf die erste Seite 18 der Leiterplatte 10. Hier wird deutlich, dass die Metallhülse 36 der Anschlussbohrung 19 nicht nur die Anschlussbohrung 19 auskleidet, sondern ringförmig um die Anschlussbohrung 19 herum ein lötbares Auge zwischen der äußeren Leiterbahn 14 und dem Anschlusspad 16 bildet, an dem der für die betreffende Anschlussbohrung 19 vorgesehene Anschlusspin verlötet wird. Deutlich sind in Fig. 3 der von den Sacklochbohrungen 20, 26 gebildete Klemmkragen 30 (siehe Fig. 1 und 2) und sein lichter Durchgang 32 erkennbar.

In der Praxis hat sich gezeigt, das der lichte Durchgang 32 im Klemmkragen 30 der Anschlussbohrung 19, der die Einpress- bzw. Haltekraft für den dort vorgesehenen Anschlusspin bestimmt, allein durch bohrtechnische Maßnahmen und Galvanisierung häufig nicht zufrieden stellend eingestellt werden kann. Erschwerend kommt hinzu, dass die Fertigungstoleranzen bei Anschlusspins von THT-Bauteilen ebenfalls nicht zufrieden stellen. Es ist daher wünschenswert, die betrachtete Anschlussbohrung 19 und den für die Anschlusspins von THT-Bauteilen vorgesehenen Klemmkragen 30 auf einfache Weise optimieren zu können. Dies wird, wie in Fig. 4 illustriert, durch eine Nachbearbeitung des Klemmkragens 30 mit einem Einpressstempel 38 möglich, der dazu dient, den metallisierten Klemmkragen 30 bzw. seinen lichten Durchgang 32 kontrolliert zu verformen, um ihn besser an den tatsächlichen Durchmesser und die Form des für die betreffende Anschlussbohrung vorgesehenen Anschlusspin anzupassen. Der Einpressstempel 38 weist dazu vorteilhafterweise einen polygonalen Querschnitt auf und, wie in Fig. 4 dargestellt, eine konische, aber abgerundete Spitze 39. Die Konizität der Spitze 39 des Einpressstempels 38 hilft beim Einsetzen des Einpressstempels 38 in die zu bearbeitende Anschlussbohrung 19 und zentriert den Einpressstempel 38 in gewünschter Weise. Je länger der konische Bereich des Einpressstempels 38 ausgeführt wird, desto feiner und kontrollierter kann der Klemmkragen 30 verformt werden.

Eine andere Möglichkeit den Klemmkragen 30 kontrolliert zu verformen besteht darin eine im wesentlichen drei-, vier-, fünf-, sechs- oder achteckige Querschnittsform für den Einpressstempel 38 zu wählen, um auf diese Weise den Klemmkragen 30 in seiner Form an den tatsächlichen Durchmesser und die Form des für die betreffende Anschlussbohrung 19 vorgesehenen Anschlusspin anzupassen und die gewünschte Einpress- und Haltekraft einzustellen.

In der in Fig. 4 gewählten Darstellung wurde der Einpressstempel 38 bereits in die Anschlussbohrung 19 gepresst und hat den Klemmkragen 30 konisch verformt, was im Vergleich zum Klemmkragen 30 der Fig. 3 deutlich wird. Wie in Fig. 4 veranschaulicht befindet sich die Leiterplatte 10 beim Einpressen des Einpressstempels 38 sinnvollerweise auf einer hier nicht näher erläuterten Auflage 40, wobei vorzugsweise im Bereich der zu bearbeitenden Anschlussbohrung 19 ein Widerlager 42 bzw. Anschlag für die Spitze 39 des Einpressstempels 38 vorgesehen ist. Damit lässt sich eine Beschädigung der Leiterplatte 10 vermeiden und die Eindringtiefe des Einpressstempels 38 steuern.

In den Fig. 5 und 6 ist die Anschlussbohrung 19 nach Fig. 4 dargestellt, und zwar in einer Draufsicht auf die erste Seite 18 der Leiterplatte 10. Deutlich ist jeweils ein erfindungsgemäß deformierter Bereich 44 des Klemmkragens 30 in der Anschlussbohrung 19 erkennbar. Im Fall des in Fig. 5 dargestellten Beispiels wurde ein Einpressstempel 38 mit viereckigem Querschnitt verwendet, im Fall des in Fig. 6 dargestellten Beispiels ein Einpressstempel 38 mit sechseckigem Querschnitt.

Es ist klar, dass das oben zur Herstellung einer einzelnen Anschlussbohrung 19 mit Klemmkragen 30 Gesagte auch für die Herstellung weiterer derartiger Anschlussbohrungen 19 auf einer Leiterplatte 10 gilt. Werden mehrere Einpresstempel 38 auf einer Trägerplatte angeordnet, so können in einem Arbeitsgang eine entsprechende Vielzahl von Anschlussbohrungen 19 auf einer Leiterplatte oder, wenn die Trägerplatte groß genug ist, mehrere Leiterplatten 10, die in einem Nutzen verbunden sind, behandelt werden.

In Fig. 7 ist eine solche erfindungsgemäße Trägerplatte 46 mit einer Vielzahl von Einpressstempeln 38 veranschaulicht. Dabei können je nach Anforderung Einpressstempel 38 verschiedenen Querschnitts verwendet werden. Dazu kann eine solche Trägerplatte 46 mit einer Vielzahl unterschiedlicher Einpressstempel 38 mit unterschiedliche Widerlager 42 (siehe dazu Fig. 4-6) für unterschiedliche Anschlussbohrungen 19 einer Leiterplatte 10 oder Nutzen und/oder im Zusammenwirken mit verschiedenen Einpressstempeln 38 mit verschiedenen Querschnittsformen und Längen verwendet werden. Bei entsprechend gewählter Länge der Einpressstempel 38 ist es denkbar, dass mehrere Leiterplatten bzw. Nutzen stapelweise verarbeitet werden, indem der oder die Einpressstempel 38 auf der Trägerplatte 46, in Anschlussbohrungen 19 mehrerer übereinander liegender Leiterplatten 10 eingepresst werden.

### Bezugszeichenliste

| | | | |
|---|---|---|---|
| 10 | Leiterplatte | 30 | Klemmkragen |
| 12 | leitende Innenschicht | 32 | lichter Durchgang |
| 14 | äußere Leiterbahn | 34 | dritte Bohrung |
| 16 | Anschlusspad | 36 | Metallhülse |
| 18 | 1. Seite Leiterplatte | 38 | Einpressstempel |
| 19 | Anschlussbohrung | 39 | konische Spitze von (38) |
| 20 | erste Sacklochbohrung | 40 | Auflage |
| 22 | Bohrlochspitze von (20) | 42 | Widerlager |
| 24 | 2. Seite Leiterplatte | 44 | deformierter Bereich von (36) |
| 26 | zweite Sacklochbohrung | 46 | Trägerplatte |
| 28 | Bohrlochspitze von (26) | CL | Mittellinie |

## Patentansprüche

1. Verfahren zur Herstellung von Anschlussbohrungen (19) mit optimierten Klemmkragen (30) in einer Leiterplatte (10) mit folgenden Verfahrensschritten:
a) Herstellen der Anschlussbohrungen (19) mittels ersten Sacklochbohrungen (20) von der ersten Seite (18) der Leiterplatte (10) her und zweiten Sacklochbohrungen (26) von der zweiten Seite (24) der Leiterplatte (10) her, derart, dass sich die jeweils zu einer Anschlussbohrung (19) gehörenden zwei Sacklochbohrungen (20, 26) in ihren Bohrlochspitzen 22, 28) wenig überdecken;
b) galvanisieren der Anschlussbohrungen (19) der Leiterplatte (10) und Schaffung einer Metallhülse (36) in den Anschlussbohrungen(19); und
c) einführen und einpressen eines Einpresstempels (38) mit polygonalem Einpressquerschnitt in die Anschlussbohrungen (19) zum Verformen der Metallhülse (36) im Bereich des Klemmkragens 30).

2. Verfahren nach Anspruch 1, bei dem zwischen den Schritten a) und b) von einer Seite (18 oder 24) der Leiterplatte (10) her im Zentrum der Sacklochbohrungen (20, 26) eine die beiden Sacklochbohrungen (20, 26) durchgreifende dritte Bohrung (34) mit einem gegenüber den Sacklochbohrungen (20, 26) kleinerem Durchmesser gebohrt wird.

3. Verfahren nach einem der Ansprüche 1 oder 2, eine Vielzahl von Einpresstempeln (38) auf einer Trägerplatte (46) angeordnet sind, so dass entsprechend dem Verfahrensschritt c) nach Anspruch 1 in einem Arbeitsgang eine Vielzahl von Anschlussbohrungen (19) der Leiterplatte (10) behandelt werden können.

4. Verfahren nach einem der Ansprüche 1 oder 2, bei dem eine Vielzahl von Einpresstempeln (38) auf einer Trägerplatte (46) angeordnet sind, so dass entsprechend dem Verfahrensschritt c) nach Anspruch 1 in einem Arbeitsgang eine Vielzahl von Anschlussbohrungen (19) mehrerer Leiterplatten (10) in einem Nutzen behandelt werden können.

5. Verfahren nach einem der Ansprüche 1-4, bei dem mehrere Einpresstempel (38) mit unterschiedlichem Querschnitt auf einer Trägerplatte (46) angeordnet sind.

6. Verfahren nach einem der vorgehenden Ansprüche 1-5, bei dem wenigstens ein Einpresstempel (38) in dem Bereich, der in die Anschlussbohrungen (19) eingepresst wird, eine Konizität (39) aufweist.

7. Verfahren nach einem der vorgehenden Ansprüche 1-6, bei dem die Leiterplatte (10) bzw. der Nutzen beim Einpressvorgang auf einer Auflage (40) aufliegt und unter jeder zu behandelnden Anschlussbohrung (19) ein Widerlager (42) vorgesehen ist.

8. Verfahren nach einem der vorgehenden Ansprüche 1-7, bei dem die Leiterplatten (10) bzw. Nutzen stapelweise verarbeitet werden, indem der oder die Einpressstempel (38), bei Mehrfachanordnung von Einpressstempeln (38) auf der Trägerplatte (46), in Anschlussbohrungen (19) mehrerer übereinander liegender Leiterplatten (10) eingepresst werden.
